Europäisches Patentamt

European Patent Office

Office européen des brevets

(19)

(11) Publication number: **0 297 231 B1**

(12) # EUROPEAN PATENT SPECIFICATION

(45) Date of publication of patent specification: **08.06.94**   (51) Int. Cl.⁵: **C25D 1/08**, H05K 9/00

(21) Application number: **88106271.5**

(22) Date of filing: **20.04.88**

(54) **Electroforming shielding elements against electromagnetic pulses.**

(30) Priority: **28.04.87 US 43918**
   **28.04.87 US 43919**
   **28.04.87 US 43920**
   **21.05.87 US 52293**

(43) Date of publication of application:
   **04.01.89 Bulletin  89/01**

(45) Publication of the grant of the patent:
   **08.06.94 Bulletin  94/23**

(84) Designated Contracting States:
   **DE FR GB IT**

(56) References cited:
   **FR-A- 850 302**
   **US-A- 4 246 076**

(73) Proprietor: **PPG INDUSTRIES, INC.**
   **One PPG Place**
   **Pittsburgh Pennsylvania 15272(US)**

(72) Inventor: **Postupack, Dennis Sylvester**
   **155 York Drive**
   **Natrona Heights, Pa. 15165(US)**
   Inventor: **Graham, Charles Richard**
   **208 Wadsworth Drive**
   **Glenshaw, Pa. 15116(US)**
   Inventor: **Pressau, Jean Pierre**
   **610 Jefferson Street**
   **Evans City, Pa. 16033(US)**

(74) Representative: **Sternagel, Hans-Günther, Dr. et al**
   **Patentanwälte Dr. Michael Hann**
   **Dr. H.-G. Sternagel**
   **Sander Aue 30**
   **D-51465 Bergisch Gladbach (DE)**

## Description

The present invention relates generally to the art of electroforming, and more particularly to the art of electroforming a grid which provides shielding from electromagnetic pulse (EMP) effects.

Electroforming of precision patterns, such as those used in optical systems, has been accomplished by several methods. For example, precision mesh patterns have been produced by electroplating onto a master pattern of lines formed by etching or ruling lines into a glass substrate and depositing a conductive material into the etched or ruled lines to form a conductive master pattern for electroplating. A major disadvantage of this method is the limitation on the fineness and precision of etching glass.

Photolithographic techniques have also been used to produce patterned electroforming mandrels. For example, a conductive substrate, such as a polished stainless steel plate, is coated with a layer of photoresist. A patterned photomask is placed over the photoresist, which is then exposed to actinic radiation through the mask, thereby creating a pattern of exposed and unexposed photoresist which is further developed. Either the exposed or the unexposed portions of the photoresist are removed, depending on whether a positive or negative pattern is desired, resulting in a conductive pattern on the substrate. An electroplating process is then carried out to form a replica of the conductive pattern which can thereafter be removed from the substrate.

U S-A-3,703,450 to Bakewell discloses a method of fabricating precision conductive mesh pattern on a repetitively reusable master plate comprising a glass plate coated with a conductive metal pattern and an array of silicon monoxide deposits in the interstitial spaces in the conductive pattern. Replicas of the conductive pattern are formed by electroplating.

U S-A-3,833,482 to Jacobus discloses a matrix for the formation of fine mesh comprising a base plate, a photoresist defining the mesh pattern, and a silica coating encapsulating the top of the base plate and the photoresist. A layer of electrically conductive metal is sputtered over the entire surface of the matrix, followed by removal of the conductive metal from the top surface of the resist on the matrix. The matrix is then suitable for electroforming on the layer of conductive metal located in the recess of the matrix.

U S-A-3,878,061 to Feldstein discloses a matrix comprising a highly polished, degenerately doped silicon single crystal substrate having a layer of inorganic dielectric thereon and a pattern of grooves in the dielectric coating exposing the silicon surface.

"A New and Unique Element for Aircraft Transparencies" by Olson et al from the Conference on Aerospace Transparent Materials and Enclosures, December 1983, describes an element comprised of myriad thin filaments prepared by a photolithographic/chemical processing method which involves generating a master pattern, producing a photomask of the pattern, applying a conductive metal layer over a substrate, coating the metal layer with photoresist, exposing the photoresist through the photomask, developing the photoresist, and placing the substrate in an etchant to remove the unwanted material leaving only the desired pattern, which functions as a heating element.

Grids for electromagnetic pulse (EMP) and microwave attenuation have been used in special purpose aircraft transparencies for a number of years. Most of the EMP energy lies between 10 kHz and 100 mHz, and the pulse is characterized by electromagnetic fields with short rise times (a few nanoseconds) and a high peak electric field amplitude (50 kilovolts per meter). EMP grids fabricated by chemical machining have been acceptable for attenuating EMP. However, such coarse-line orthogonal patterns have been nonuniform, especially in cross-section.

It is the object of the present invention to provide a method for producing a metal grid having a more uniform cross-section and finer lines for use in a transparency capable of attenuating the effects of electromagnetic pulse.

This object is attained by a method for producing a metal grid for use in a transparency to attenuate the effects of electromagnetic pulse comprising the steps of:

    a. providing a metal substrate with a surface capable of bonding with a photoresist;

    b. applying a layer of photoresist to said metal surface;

    c. exposing said photoresist to actinic radiation through a photomask imaged with a grid pattern comprising at least one hundred apertures per 6.451 $cm^2$ to produce exposed portions of photoresist with solubility differing from unexposed portions;

    d. developing said photoresist in a solvent which removes portions thereof to expose said grid pattern on said metal surface to provide an electroforming mandrel;

    e. oxidizing said exposed metal surface of said electroforming mandrel;

    f. immersing said mandrel in a solution comprising metal ions;

    g. applying an electrical potential between an anode and said mandrel as cathode;

    h. electrodepositing metal on the exposed metal mandrel surface in said grid pattern;

i. removing said mandrel bearing said electrodeposited metal grid pattern from said solution; and

j. removing said grid pattern from said mandrel.

The solution includes a transparent article capable of attenuating the effects of electromagnetic pulse comprising:

a. a transparent substrate; and

b. an electroformed metal grid comprising at least one hundred apertures per 6.451 cm$^2$ (inch$^2$).

The grid pattern is preferably nonorthogonally comprising nonlinear segments. The nonorthogonally grid pattern may comprise a series of closed loops, equally spaced and interconnected by arcs.

A fine-line orthogonal grid fabricated by the electroforming process in accordance with the present invention has improved optics and shielding characteristics with a uniform nearly square cross-section.

Electrically, small apertures in an electromagnetic shield are best characterized in terms of magnetic and electric field polarizabilities. An electrically small aperture can be defined as having dimensions significantly less than a wavelength at the highest frequency of interest. In the case of EMP, this frequency is on the order of 100 mHz, corresponding to a wavelength of three meters. Thus, apertures of about one-half meter could be considered reasonably small. Since a typical aircraft transparency has dimensions on this order, the application of a grid to the transparency can provide EMP shielding without substantially compromising visibility.

Polarizabilities of an aperture are the quantities which relate the external incident fields to the equivalent dipole moments for the electric and magnetic fields inside the aperture. Since the polarizabilities depend only on the size and shape of the aperture, they can be used to define a complete electromagnetic description of the aperture. The polarizabilities are found to vary as the cube of the aperture diameter. The term "normalized polarizabilities" is used to describe the attenuation effect of placing a thin film or metallic grid over an aperture. Normalized polarizability, $a_n$, is defined as the ratio of the polarizability of the shielded aperture, $a$, to the polarizability of the open aperture, $a_o$. The "shielding effectiveness" of an EMP shielded transparency is directly dependent on the normalized polarizability as shown in the following equation:

$$20 \log(a/a_o) = 20 \log a_n.$$

Since the electroforming method of the present invention produces finer lines of more uniform cross-section, a greater grid density is possible, i.e., more apertures in a given surface area. Since dividing an aperture into N apertures reduces the penetration field by $1/N$, the shielding effectiveness is improved by increasing the grid density with the finer grid lines provided by the method of the present invention. By replacing the straight lines of a conventional grid pattern with nonlinear segments in accordance with a preferred embodiment of the present invention, a flexible grid with improved optics and capable of conforming to a curved substrate is produced. Moreover, the preferred nonorthogonal grid patterns of the present invention provide improved optical properties and greater physical flexibility to conform to compound curves and complex shapes. Copper EMP shielding grids having a reflective surface which may be distracting to one looking through the shielded transparency are given a non-glare surface treatment in accordance with the present invention.

The present invention provides an electroforming process for producing a grid which provides electromagnetic pulse (EMP) shielding. A substrate transparent to actinic radiation is provided with a desired pattern for the EMP shielding grid to form a photomask. A substrate with a conductive surface is used as the electroforming mandrel. A continuous layer of photoresist is deposited over the conductive surface of the mandrel. The photoresist is exposed to actinic radiation through the photomask, the pattern acting to mask portions of the photoresist from exposure. The photoresist is then developed, and the unexposed portions removed to yield a conductive pattern of the underlying conductive mandrel surface corresponding to the pattern of the photomask. The mandrel is immersed in an electroforming solution, and current is applied to effect the electrodeposition of metal onto the conductive pattern area on the mandrel. When a sufficiently thick deposit is obtained, the remaining photoresist is removed, and the electroformed EMP shielding grid is separated from the mandrel.

The present invention further provides electroformed grids with a superior design preferably for use on substrates with compound curved or complex shapes which involves modifying a conventional square grid pattern by replacing linear segments of the square with nonlinear segments so that the grid may simultaneously stretch and contract in different areas or directions in order to conform to a compound curved or complex shaped substrate. According to one embodiment the conformable electroformed grid is finally assembled with a transparent substrate to form, ultimately, a curved transparency with a conforming grid.

The present invention also provides superior nonorthogonal patterns for producing a grid which provides electromagnetic pulse (EMP) shielding.

The nonorthogonal patterns according to one embodiment of the present invention provide equivalent shielding effectiveness to that provided by orthogonal grids of the prior art while improving the optical performance by reducing diffraction interference patterns ("starburst" effect). In addition, the nonorthogonal patterns of the present invention are readily conformable to compound curved and complex shaped substrates.

The present invention further improves an electroforming process for producing a grid which provides electromagnetic pulse (EMP) shielding by electroforming a grid of any suitable configuration as described above. The metal grid is then electroplated with a tin/lead coating to reduce the reflectance. Finally, a reverse polarity electrochemical treatment in an acid medium is carried out to darken and harden the tin/lead coating and further reduce the reflectance.

Description of the Drawings

Figure 1 shows the shielding effectiveness of an EMP shielding grid (STD) of the present invention compared with that of a chemically machined grid ($B_2$) of the prior art. The E field (electrical) shielding effectiveness is shown at the top of Figure 1, and the H field (magnetic) shielding effectiveness at the bottom.

Figure 2 illustrates a conformable pattern wherein a conventional square grid is modified by replacing straight line segments with interconnected alternating hemispheres.

Figure 3 compares the shielding effectiveness of nonorthogonal EMP shielding grids (A3 and A5) of the present invention with that of an orthogonal grid (STD) of the prior art. The E field (electrical) shielding is shown at the top of Figure 3, and the H field (magnetic) shielding effectiveness is shown at the bottom.

Figure 4 illustrates a pattern of circles interconnected by pairs of arcs having the dimensions described in Example III.

Figure 5 illustrates a pattern of circles interconnected by pairs of arcs having the dimensions described in Example IV.

Detailed Description of the Preferred Embodiments

In a preferred embodiment of the present invention, a photomask master plate is provided with a pattern representing the configuration of the EMP shielding grid to be produced by electroforming. A substrate with a conductive surface is used as an electroforming mandrel, preferably a sheet of nickel or stainless steel. A continuous layer of photoresist is applied over the conductive surface of the mandrel. Any conventional photoresist with sufficient resolution is acceptable.

In a preferred embodiment of the present invention, photoresist in sheet form is laminated to the conductive surface of the mandrel. The photoresist is exposed to actinic radiation through the photomask to cure the exposed portions of the photoresist. The photomask pattern masks portions of the photoresist from exposure, and these portions remain uncured. Following exposure of the photoresist, and a post-curing cycle if necessary, the photoresist is developed.

Preferably, the photoresist is contacted with a chemical solution which dissolves and removes the unexposed, uncured portions of the photoresist, thereby providing a pattern of the underlying conductive film which is a positive image of the pattern in the photomask. The remaining exposed, cured portions of the photoresist surrounding the conductive pattern form walls within which the electroformed grid is subsequently deposited. In an alternative embodiment of the present invention, a positive working photoresist may be employed to form a conductive film pattern which is a negative image of the photomask pattern.

The resulting article is employed as a mandrel for the electroforming of a metallic EMP shielding grid, which is a replication of the pattern on the conductive surface of the mandrel. In accordance with the present invention, the exposed metal pattern on the mandrel surface is treated to produce a slightly oxidized surface which facilitates subsequent release of the electroformed grid from the mandrel.

The back side of the mandrel is covered with a nonconductive material to prevent deposition of metal except on the pattern. Then the mandrel is immersed in a metal-containing electrodeposition solution. Preferred electroforming solutions comprise nickel or copper salts, preferably nickel sulfamate or copper sulfate. An electrical circuit is established, using the conductive mandrel surface as the cathode and an electrode of the metal to be deposited as the anode. Preferred anodes comprise nickel or copper. An electrical potential is applied, and metal is deposited on the conductive exposed mandrel surface in the pattern as defined by the nonconductive photoresist. Electrodeposition is continued until the desired thickness is obtained for the electroformed EMP shielding grid.

The substrate bearing the photoresist and electroformed EMP shielding grid is removed from the electrodeposition solution. Separation of the electroformed EMP shielding grid from the mandrel may be effected by various means, such as alternately heating and chilling. In certain applications wherein the electroformed EMP shielding grid is very thin and/or comprises very fine lines, the remaining photoresist is first removed, preferably by dissolution. Then the electroformed grid is lifted off the mandrel. In other applications, the electroformed grid may be separated from the mandrel without removing the remaining photoresist, permitting immediate reuse of the mandrel. In most preferred embodiments of the present invention, wherein the electroformed EMP shielding grid comprises very fine lines, a preferred method for separating the electroformed heating element from the mandrel is to remove the photoresist and carefully peel the electroformed grid from the mandrel surface.

In a most preferred embodiment of the present invention, a photomask is prepared by coating a plate with a photographic emulsion comprising silver halide which is exposed to actinic radiation through a master pattern in the shape of the grid to be electroformed. Exposed areas of the photographic emulsion form a latent image which is developed by immersion in developing solutions which convert the silver halide to colloidal silver.

An electroforming mandrel is preferably prepared by cleaning a surface of a stainless steel substrate. A continuous layer of photoresist is applied over the conductive surface of the stainless steel sheet preferably by laminating a sheet of photoresist to the stainless steel surface, e.g. at a temperature of (235°F) 113°C . A preferred photoresist layer having a thickness of (0.001 inch) 0.025 millimeter is available from Thiokol/Dynachem Corporation of Tustin, California. The photoresist is preferably exposed to actinic radiation through the photomask for about 20 seconds and cured. The photoresist is developed with a solvent which removes the unexposed portions of the photoresist thereby providing a conductive pattern on the underlying stainless steel mandrel surface. The resultant electroforming mandrel is preferably treated to form a slightly oxidized surface on the exposed metal pattern, preferably by contact with a strong acid, in order to facilitate subsequent release of the electroformed grid.

The mandrel is immersed in an electroforming solution preferably comprising copper sulfate and utilizing a copper anode in order to electroform a highly conductive copper grid which provides substantial EMP shielding when applied to a transparency. While conventional square grid patterns may be electroformed in accordance with the present invention, nonlinear grids with improved optical properties and flexibility are preferred.

In a preferred embodiment of the present invention, a photomask master plate is provided with a pattern representing the configuration of a conformable grid to be produced by electroforming. In one preferred embodiment of the present invention, a mandrel is immersed in an electroforming solution preferably comprising copper sulfate and utilizing a copper anode in order to electroform a highly conductive conformable copper grid which provides substantial EMP shielding to a curved transparency. The nonlinear grids of the present invention are preferably used in laminates with glass and/or rigid transparent plastics such as polycarbonate and acrylic, preferably further comprising an elastomeric layer such as polyvinyl butyral or polyurethanes. Such laminated articles are particularly useful as aircraft windshields.

A particularly effective pattern is a network of closed loops interconnected by curved lines. A highly conductive metallic grid pattern laminated in an aircraft transparency must demonstrate excellent optical properties as well as effective EMP shielding for the electronic equipment. A fine-line orthogonal grid pattern, although an effective EMP shielding design, introduces an objectionable optical distortion problem for the crew, especially under night vision conditions. Fraunhofer diffraction interference patterns produced by the square apertures of the grid pattern cause a "starburst" visual effect from incident light. The fine-line nonorthogonal grid patterns of the present invention are designed with a continuous series of interconnected closed loop apertures, particularly circles interconnected by arcs, preferably pairs of arcs. The Fraunhofer diffraction interference pattern produced by circular apertures is diffusely circular and not as severe a visual disturbance as the "starburst" pattern of an orthogonal grid.

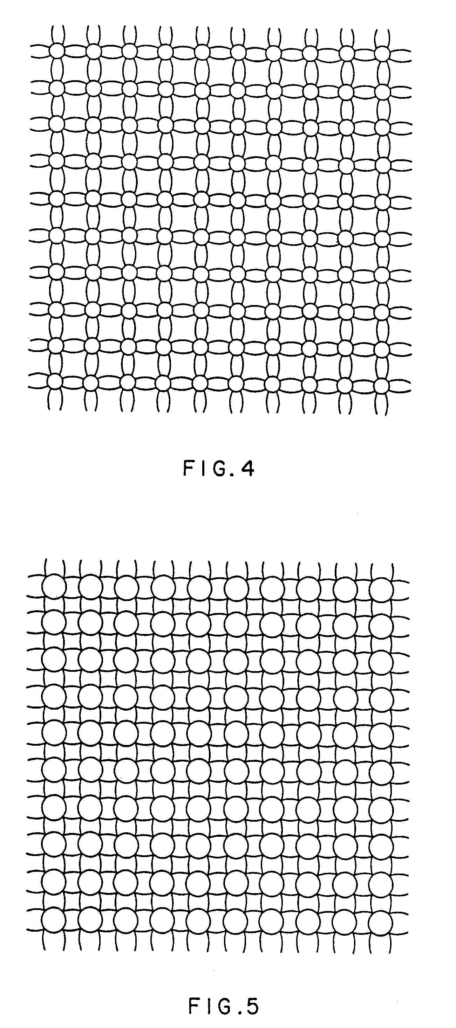

In addition, an orthogonal grid which has sufficient physical flexibility to conform to a simple curve such as a cylindrical surface does not have sufficient degrees of freedom to conform to compound curvatures or complex shapes without wrinkling or buckling. For an orthogonal grid, the mechanical characteristics and limitations are similar to those of a thin flat sheet. When an orthogonal grid is to be used for EMP shielding of aircraft window transparencies which have compound curvature shapes, the grid wrinkles or buckles when laminated with a transparent substrate. In such applications, a grid must adhere to rigid physical dimensions with very limited tolerances in order to properly function as an EMP shield. The nonorthogonal grid patterns of the present invention preferably of a conductive metal modify the mechanical characteristics from those of a thin flat sheet by replacing equally spaced square grids with a network of closed loops, preferably circles, interconnected by arcs, preferably in pairs, in a uniform pattern which readily conforms to compound curves and complex shapes. With the nonorthogonal grid patterns of the present invention, lamination processes or molding procedures are accomplished with reasonably uniform shaping forces because the overall nonorthogonal grid conforms to the curvature and shape of the substrate with minimal wrinkling. The nonorthogonal grid patterns illustrated in Figures 4 and 5 demonstrate a substantial increase in flexibility and conformability compared with a standard square grid pattern.

The nonorthogonal patterns of the present invention may be produced by the same procedures and processes used to produce conventional flat square EMP grids; the only difference is in the artwork pattern. A mathematical algorithm can be defined using trigonometric functions to prepare a computer assisted design (CAD) program to generate plot commands for a high precision photoplotter. The film generated by the photoplotter contains the pattern image, becoming the artwork used to produce a photomask, which is used to reproduce the nonorthogonal pattern on a mandrel, which in turn is used in an electroforming process to produce a nonorthogonal grid.

A basic algorithm used to generate the network pattern previously described for an EMP shielding pattern is defined as an evenly spaced matrix of equal sized circles aligned in rows and columns. The size of the circles and the spacing between them are defined in terms of the radius of a circle $R_1$. The spacing from center to center in both horizontal rows and vertical columns is preferably three times $R_1$, where $R_1$ may also be the radius of the circles, $R_3$. The nodes of the matrix are the previously described circles. The spacing of the nodes ($3 \times R_1$) can be maintained constant while the radius of the circles ($R_3$) is increased or decreased to alter the flexibility of the grid. Similarly the radius of curvature of the arcs can be changed, as well as the spacing between nodes.

The nonorthogonal grid provides substantial EMP shielding when applied to a transparency, while minimizing optical disruptions such as "starburst" patterns. The nonorthogonal configuration of the grids of the present invention permit lamination in compound curvatures and complex shapes without wrinkling or buckling. The nonorthogonal grids of the present invention are preferably laminated in transparencies comprising layers of glass or rigid transparent plastics such as polycarbonate and acrylic, and preferably further comprising an elastomeric layer such as polyvinyl butyral and polyurethanes. Such laminates are particularly useful as aircraft windshields.

The electroformed grid, of any configuration, is preferably immersed in an electroplating solution, preferably a conventional solder bath, to deposit a tin/lead coating on the metal grid surfaces to reduce the reflectance. At a current density of 25 to 30 amps per 929 cm² (square foot) tin/lead electroplating proceeds at a rate of about (0.004 inch) 0.1 millimeter per hour. The tin/lead coating is inherently soft, and shiny spots appear in areas exposed to abrasion. Therefore, the tin/lead coated grid is immersed in an acid solution and subjected to a reverse polarity electrochemical treatment which darkens and hardens the tin/lead coating and further reduces the reflectance. The tin/lead coating provides corrosion resistance, as well as improved optics, to the electroformed grid. The electroformed grids of the present invention are preferably laminated in transparencies comprising layers of glass and/or rigid transparent plastics such as polycarbonate and acrylic, and preferably further comprising an elastomeric layer such as polyvinyl butyral and polyurethanes. Such laminates are particularly useful as aircraft windshields.

The present invention will be further understood from the descriptions of specific examples which follow.

EXAMPLE I

A stainless steel mandrel measuring about 0.61 by 0.91 meters (24 by 36 inches) is degreased, roughened and cleaned with detergent and hydrochloric acid. A sheet of negative-working dry photoresist about 0.038 millimeter (0.0015 inch) thick is laminated to a surface of the mandrel. An imaged photomask having a desired EMP grid pattern is placed in contact with the photoresist-coated mandrel surface. The photomask-mandrel stack is placed in an ultraviolet radiation exposure chamber to activate the photoresist, producing a negative image. The photoresist is developed, removing the exposed portion to yield a conductive pattern on the mandrel surface. The patterned mandrel is heated for 30 minutes at about 121°C (250°F) to improve the adhesion of the photoresist.

After cooling, the back side of the mandrel, i.e. opposite the photoresist pattern coated side, is co ered with a nonconductive material to prevent electrodeposition of metal onto the back surface. The mandrel is further cleaned by dipping in 10 percent hydrochloric acid for 30 seconds and rinsing. A preferred reverse polarity cleaning procedure is carried out by immersing the mandrel in an alkaline cleaning solution and applying a current of 2 amps for a period of 2 minutes with the mandrel functioning as the anode in order to form an oxidized surface on the conductive metal pattern which facilitates subsequent release of the electroformed grid. Following the reverse polarity cleaning, the mandrel is immersed in 5 percent nitric acid for 15 minutes and then rinsed.

Finally, the mandrel is immersed in an electroforming solution containing vertically oriented anodes, preferably having at least the same surface area as the mandrel. An electrical potential is applied between the anodes and the mandrel, which functions as the cathode. Metal atoms from the anode enter the solution as ions, while ions from the solution deposit as metal on the cathode, i.e. the conductive mandrel surface. The electroforming solution comprises about 225 grams per liter copper sulfate, and is used at ambient temperature, about 21°C (70°F). At a current density of about 80 amps per 929 cm$^2$ (square foot) of exposed metal mandrel surface, copper is deposited at a rate of about 0.76 millimeter (0.003 inch) per hour. The electroforming reaction is continued until the desired copper thickness is obtained. In this example, with a photoresist thickness of about 0.038 millimeter (0.0015 inch) and a pattern line width of about 0.043 millimeter (0.0017 inch), the electroforming reaction is continued to a copper thickness of about 0.043 millimeter (0.0017 inch), resulting in a maximum line width of about 0.054 millimeter (0.0021 inch).

To remove the electroformed grid from the mandrel, the coated mandrel is placed in bath containing solvent, preferably heated to about 54°C (130°F), which removes the photoresist from the mandrel surface. The electroformed grid is then lifted from the mandrel surface for subsequent lamination in a transparency. The resistivity of the grid is about 22 milliohms per square.

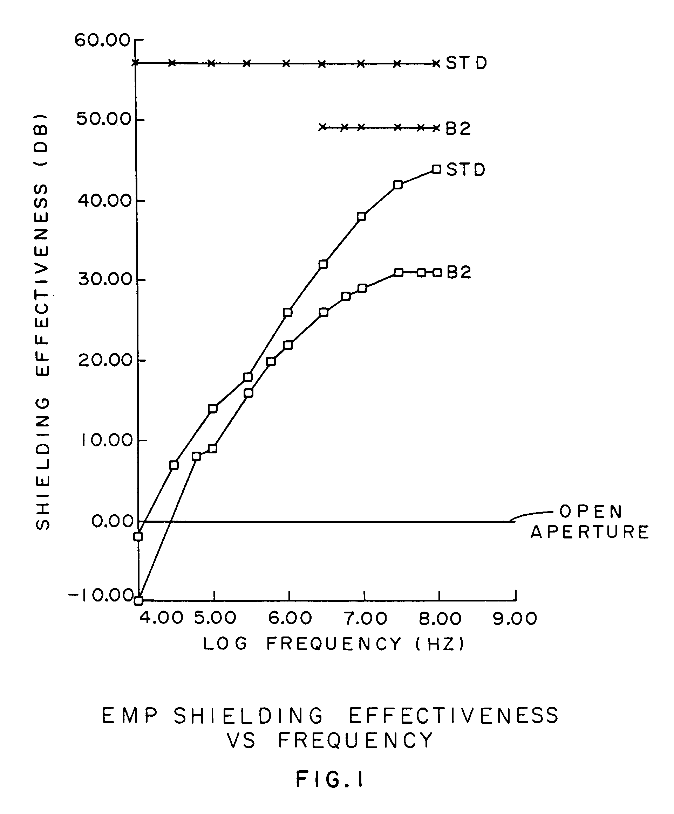

The normalized polarizabilities of the electroformed grid are measured in a DNA/JAYCOR dual transverse electromagnetic wave (TEM) cell in which the electric field is normal and the magnetic field is parallel to the test material. The dual TEM cell was chosen over most other EMP testing equipment since the results calculated are both E field (electrical) and H field (magnetic) shielding effectiveness. To obtain a normalized polarizability, the evaluation includes background or noise level tests with and without a solid metallic shield within the aperture, tests of the unshielded aperture and tests with the EMP shielded sample in place. Samples are carefully placed in the test chamber to insure that the contact impedance is less than 0.1 milliohm. The results of these tests are shown in Figure 1, comparing the electroformed grid of the present invention with a chemically machined grid of the prior art.

## EXAMPLE II

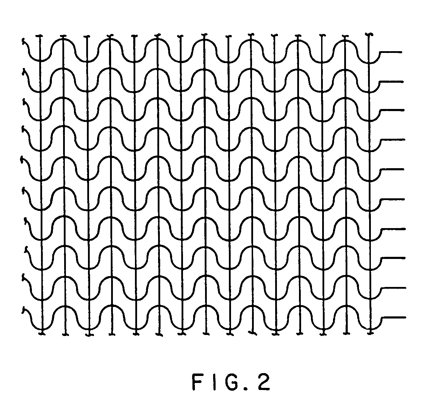

A stainless steel mandrel measuring 0.61 by 0.91 meters (24 by 36 inches) is degreased, roughened and cleaned with detergent and hydrochloric acid. A sheet of negative-working dry photoresist about 0.038 millimeter (0.0015 inch) thick is laminated to a surface of the mandrel. An imaged photomask having a desired nonlinear grid pattern as shown in Figure 2 is placed in contact with the photoresist-coated mandrel surface. The photomask and mandrel are prepared as in the previous example and immersed in an electroforming solution which comprises nickel sulfamate, so that metallic nickel forms in the pattern of the photoresist on the mandrel surface. The electroforming reaction is continued until the desired nickel thickness is obtained. In this example, with a photoresist thickness of about 0.013 millimeter (0.0005 inches) and a line width of about 0.033 millimeter (0.0013 inch), the electroforming reaction is continued to a nickel thickness of about 0.013 millimeter (0.0005 inch), resulting in a maximum line width of about 0.033 millimeter (0.0013 inch).

To remove the electroformed grid from the mandrel, the coated mandrel is placed in a bath containing solvent, preferably heated to about 54°C (130°F), which removes the photoresist from the mandrel surface. The electroformed grid is then lifted from the mandrel surface for subsequent lamination in a transparency. The pattern illustrated in Figure 2 is used to produce a nonlinear grid wherein the distance from top to top of nonadjacent hemispheres is about 2 millimeters (0.08 inch) and the distance between nonlinear segments is about 1 millimeter (0.04 inch). The nickel grid has a resistivity of about 0.25 ohms per square.

## EXAMPLE III

A nonorthogonal grid as shown in Figure 4 is designed with the following dimensions: $R_1$ = 0.84 millimeter (0.033 inch), $R_2$ = 1.8 millimeter (0.071 inch) and $R_3$ = 0.635 millimeter (0.025 inch), wherein $R_1$ is the radius of a circle which defines the spacing of the matrix (the space between nodes equals three times $R_1$), $R_2$ is the radius of curvature of the interconnecting arcs and $R_3$ is the radius of the interconnected circles. Photoplotted artwork is used to produce a photomask, which is used to reproduce the nonorthogonal pattern onto a mandrel for electroforming a nonorthogonal grid of the same pattern.

A stainless steel mandrel measuring about 0.61 by 0.91 meters (24 by 36 inches) is degreased, roughened and cleaned with detergent and hydrochloric acid. A sheet of negative-working dry photoresist about 0.038 millimeter (0.0015 inch) thick is laminated to a surface of the mandrel. An imaged photomask having a nonorthogonal EMP grid pattern as illustrated in Figure 4 is placed in contact with the photoresist-coated mandrel surface. The photomask and mandrel are prepared as in the previous examples and immersed in an electroforming solution which comprises copper sulfate, so that metallic copper forms in the nonorthogonal pattern of the photoresist on the mandrel surface. The electroforming reaction is continued until the desired copper thickness is obtained. In this example, with a photoresist thickness of about 0.038 millimeter (0.0015 inch) and a line width of about 0.043 millimeter (0.0017 inch), the electroforming reaction is continued to a copper thickness of about 0.043 millimeter (0.0017 inch), resulting in a maximum line width of about 0.054 millimeter (0.0021 inch).

To remove the nonorthogonal electroformed grid from the mandrel, the coated mandrel is placed in a bath containing solvent, preferably heated to about 54°C (130°F), which removes the photoresist from the mandrel surface. The nonorthogonal electroforming grid is then lifted from the mandrel surface for subsequent lamination in a transparency.

EXAMPLE IV

A nonorthogonal pattern as shown in Figure 5 is designed and produced as in Example III with the following dimensions: $R_1$ = 0.84 millimeter (0.033 inch), $R_2$ = 1.98 millimeter (0.078 inch) and $R_3$ = 0.84 millimeter (0.033 inch). The resistivity of the nonorthogonal grid pattern of this example is about 24 milliohms per square.

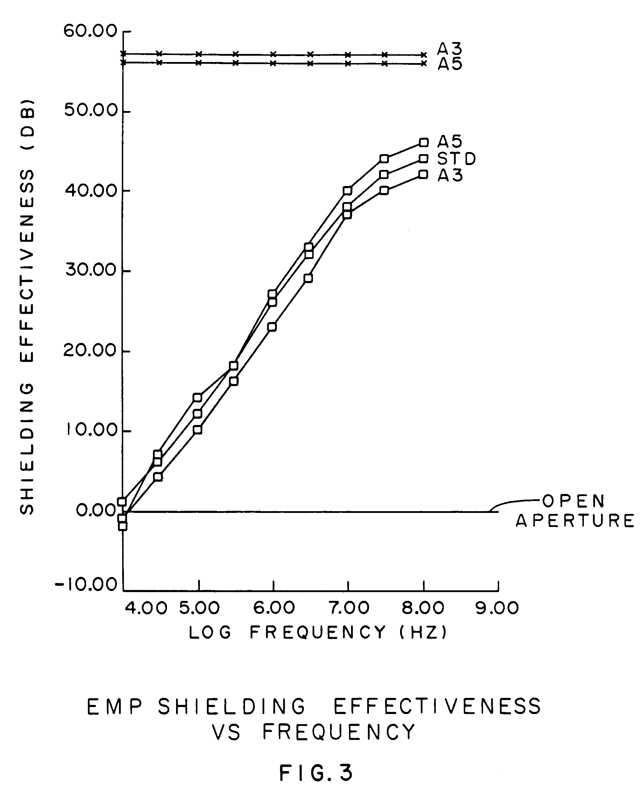

The normalized polarizabilities of the nonorthogonal electroformed grids of Examples III and IV are measured in a DNA/JAYCOR dual transverse electromagnetic wave (TEM) cell in which the electric field is normal and the magnetic field is parallel to the test material. The results of these tests are shown in Figure 3, comparing the shielding effectiveness of the nonorthogonal electroformed grid patterns of Examples III and IV (A3 and A5 respectively) of the present invention with an orthogonal electroformed grid (STD) of the prior art.

EXAMPLE V

A stainless steel mandrel measuring about 0.61 by 0.91 meters (24 by 36 inches) is degreased, roughened and cleaned with detergent and hydrochloric acid. A sheet of negative-working dry photoresist about 0.038 millimeter (0.0015 inch) thick is laminated to a surface of the mandrel. An imaged photomask having a desired EMP grid pattern is placed in contact with the photoresist-coated mandrel surface. The photomask and mandrel are prepared as in the previous examples and immersed in an electroforming solution which comprises about 225 grams per liter copper sulfate, and is used at ambient temperature, about 21°C (70°F). At a current density of about 80 amps per 929 cm² (square foot) of exposed metal mandrel surface, copper is deposited at a rate of about 0.76 millimeter (0.003 inch) per hour. The electroforming reaction is continued until the desired copper thickness is obtained. In this example, with a photoresist thickness of about 0.038 millimeter (0.0015 inch) and a pattern line width of about 0.043 millimeter (0.0017 inch), the electroforming reaction is continued to a copper thickness of about 0.043 millimeter (0.0017 inch), resulting in a maximum line width of about 0.054 millimeter (0.0021 inch).

To remove the electroformed grid from the mandrel, the coated mandrel is placed in bath containing a stripping solution, preferably heated to about 54°C (130°F), which removes the remaining photoresist from the mandrel surface. The electroformed grid is then lifted from the mandrel surface for subsequent lamination in a transparency. The resistivity of the grid is about 22 milliohms per square. The front surface of the grid has a higher reflectance than that of the surface which was in contact with the mandrel. The electroplating of lead/tin and the subsequent reverse polarity acid treatment are carried out in a manner such that the reflectance of both surfaces is comparable.

The copper grid is immersed in an electroplating solution, and a tin/lead coating is deposited over the copper to reduce the reflectance. The electroplating solution is a conventional solder bath, such as is available from Technic, Inc. of Providence, Rhode Island, comprising 60/40 tin/lead in acidic aqueous solution. The solution comprises stannous fluoborate, lead fluoborate, boric acid and free-fluoboric acid at a pH of 0.0024. The solution is maintained at a temperature between 24° and 38°C (75° and 100°F) and is mechanically agitated. At a current density of 16 amps per square foot, tin/lead electroplating is carried out with the front surface of the grid facing the anode for 2 minutes. While tin/lead is deposited on all surfaces of the grid, the surface facing the anode is electroplated to a greater degree. The electroplated electroformed grid is then immersed in an acid solution and subjected to a reverse electrochemical treatment to darken and harden the tin/lead coating, and to further reduce the reflectance. The solution comprises sodium acid sulfate and amido sulfamic acid at a pH of about 0.4 to 0.58. With the front surface of the grid facing the cathode, the grid is exposed to reverse polarity at a current density of 10 amps per 929 cm² (square foot) for 2 minutes to produce a lead/tin coating which not only reduces the reflectance of the copper grid, but provides corrosion protection as well. The electroplating and reverse polarity steps are then repeated with the grid reversed, i.e. with the back surface receiving the greatest exposure. The electroplating is carried out for 1-1/2 minutes at a current density of 8 amps per 929 cm² (square foot), and the reverse polarity acid treatment for 30 seconds at a current density of 10 amps per 929 cm² (square foot).

The above examples are offered to illustrate the present invention. Various electroforming solutions may be employed to electroform grids of other metals, or various configurations and line densities may be used for EMP shielding and other purposes. For example, higher resistance grids may be used as heating elements. Electroformed grids may be assembled with a variety of materials for use in transparencies, and may also be used to provide shielding or heating to nontransparent materials. Conformable electroformed grids may be assembled with a variety of materials for use in curved transparencies, and may also be used with nontransparent materials. While electroforming is the preferred method for producing the nonorthogonal grid patterns of the present invention, the optical and flexibility improvements obtained with nonorthogonal grid patterns are not thereby limited. Although the nonorthogonal grid pattern of the present invention is described herein as useful for EMP shielding, it is not limited to such use. For example, higher resistance nonorthogonal metallic grids may be used as heating elements. Electroplating of other metals which lower the reflectance of a conductive grid may be carried out and the reflectance maybe further reduced by other chemical or electrochemical treatments. The scope of the invention is defined by the following claims.

## Claims

1. A method for producing a metal grid for use in a transparency to attenuate the effects of electromagnetic pulse comprising the steps of:
    a. providing a metal substrate with a surface capable of bonding with a photoresist;
    b. applying a layer of photoresist to said metal surface;
    c. exposing said photoresist to actinic radiation through a photomask imaged with a grid pattern comprising at least one hundred apertures per 6.451 $cm^2$ to produce exposed portions of photoresist with solubility differing from unexposed portions;
    d. developing said photoresist in a solvent which removes portions thereof to expose said grid pattern on said metal surface to provide an electroforming mandrel;
    e. oxidizing said exposed metal surface of said electroforming mandrel;
    f. immersing said mandrel in a solution comprising metal ions;
    g. applying an electrical potential between an anode and said mandrel as cathode;
    h. electrodepositing metal on the exposed metal mandrel surface in said grid pattern;
    i. removing said mandrel bearing said electrodeposited metal grid pattern from said solution; and
    j. removing said grid pattern from said mandrel.

2. The method according to claim 1, wherein the step of immersing said mandrel in a solution comprising metal ions is accomplished using a solution of metal salt selected from the group consisting of nickel sulfamate and copper sulfate, and said anode comprises a metal selected from the group consisting of nickel and copper.

3. The method according to claim 1 further comprising the steps of:
    immersing said metal grid in a solution comprising ions of lead and tin;
    electroplating a coating of lead and tin onto said grid; and
    treating said tin/lead coating to darken and harden it and reduce its reflectance.

4. The method according to claim 3 wherein the step of treating said tin/lead coating is performed by immersing the electroplated electroformed grid in an acid solution and performing a reverse polarity electrochemical treatment.

5. The method of claim 1, wherein the grid pattern of the metal grid is nonorthogonally and comprises nonlinear segments.

6. A transparent article capable of attenuating the effects of electromagnetic pulse comprising:
    a. a transparent substrate; and
    b. an electroformed metal grid comprising at least one hundred apertures per 6.451 $cm^2$ ($inch^2$).

7. The transparent article of claim 6, wherein said electroformed metal grid comprises an electroplated nonreflective coating thereon.

8. The transparent article according to claim 7, wherein said electroformed metal grid comprises a metal selected from the group consisting of nickel and copper, and said electroplated coating comprises tin and lead.

9. The transparent article according to claim 6, wherein said transparent substrate is curved and the metal grid comprises nonlinear segments to conform with the curved substrate.

10. The transparent article according to claim 9, wherein said grid pattern of said grid is nonorthogonally and comprising a series of closed loops, equally spaced and interconnected by arcs.

**Patentansprüche**

1.  Verfahren zum Herstellen eines Metallgitters zur Verwendung in einem lichtdurchlässigen Element, um die Wirkung von elektromagnetischer Schwingung zu dämpfen, durch die Schritte:

    a) Vorlegen eines Metallträgers, dessen Oberfläche sich mit einem Photoresist verbinden kann,

    b) Aufbringen einer Photoresist-Schicht auf die Metalloberfläche,

    c) Aussetzen des Photoresists aktinischer Strahlung durch eine Photomaske mit einem Gitterbild, das mindestens 100 Öffnungen pro 6,451 cm² aufweist, um belichtete Stellen des Photoresists zu erzeugen, deren Löslichkeit sich von unbelichteten Stellen unterscheidet,

    d) Entwickeln des Photoresists mit einem Lösemittel das Stellen desselben entfernt, um das Gittermuster auf der Metalloberfläche freizulegen und ein galvanoplastisches Werkzeug auszubilden,

    e) Oxydieren der freigelegten Metalloberfläche des galvanoplastischen Werkzeuges,

    f) Eintauchen des Werkzeuges in eine Metallionen enthaltende Lösung,

    g) Anlegen einer elektrischen Spannung zwischen einer Anode und dem Werkzeug als Kathode,

    h) elektrisches Abscheiden eines Metalles auf der freigelegten metallischen Werkzeugoberfläche im Gittermuster,

    i) Entfernen des mit dem Metallgittermuster durch elektrisches Abscheiden versehenen Werkzeuges aus der Lösung und

    j) Entfernen des Gittermusters vom Werkzeug.

2.  Verfahren nach Anspruch 1,
    **dadurch gekennzeichnet,**
    daß der Schritt des Eintauchens des Werkzeuges in eine Metallionen enthaltende Lösung unter Verwendung einer Lösung von Metallsalz, ausgewählt aus der aus Nickelsulfamat und Kupfersulfat bestehenden Gruppe, ausgeführt wird und die Anode ein Metall enthält, ausgewählt aus der aus Nickel und Kupfer bestehenden Gruppe.

3.  Verfahren nach Anspruch 1,
    **gekennzeichnet durch**
    die weiteren Schritte des Eintauchens des Metallgitters in eine Ionen von Blei und Zinn enthaltende Lösung, Elektroplattieren einer Beschichtung von Blei und Zinn auf das Gitter und Behandeln der Zinn-/Bleibeschichtung, um diese dunkler werden zu lassen und zu härten und das Reflektionsvermögen zu verringern.

4.  Verfahren nach Anspruch 3,
    **dadurch gekennzeichnet,**
    daß der Schritt des Behandelns der Zinn-/Bleibeschichtung durch Eintauchen des elektroplattierten, durch Galvanoplastik gebildeten Gitters in eine saure Lösung und elektrochemisches Behandeln mit umgekehrter Polarität ausgeführt wird.

5.  Verfahren nach Anspruch 1,
    **dadurch gekennzeichnet,**
    daß das Gittermuster des Metallgitters nichtorthogonal ist und nichtlineare Segmente aufweist.

6.  Transparenter Gegenstand, der in der Lage ist, die Wirkung elektromagnetischer Schwingungen zu dämpfen, mit

    a) einem transparenten Träger und

    b) einem durch Galvanoplastik erzeugten Metallgitter, das mindestens 100 Öffnungen pro 6,451 cm² (Inch²) aufweist.

7.  Transparenter Gegenstand nach Anspruch 6,
    **dadurch gekennzeichnet,**
    daß das durch Galvanoplastik gebildete Metallgitter eine darauf durch Elektroplattieren aufgebrachte nichtreflektierende Beschichtung aufweist.

8.  Transparenter Gegenstand nach Anspruch 7,
    **dadurch gekennzeichnet,**
    daß das durch Galvanoplastik gebildete Metallgitter ein Metall enthält, ausgewählt aus der Gruppe bestehend aus Nickel und Kupfer, und die durch Elektroplattieren aufgebrachte Beschichtung Zinn und Blei enthält.

9.  Transparenter Gegenstand nach Anspruch 6,
    **dadurch gekennzeichnet,**
    daß der transparente Träger gekrümmt ist und das Metallgitter nichtlineare Segmente aufweist, um mit dem gekrümmten Träger übereinzustimmen.

10. Transparenter Gegenstand nach Anspruch 9,
    **dadurch gekennzeichnet,**
    daß das Gittermuster des Gitters nichtorthogonal ist und eine Reihe von geschlossenen Schleifen in gleichmäßigem Abstand voneinander aufweist, die durch Bögen miteinander verbunden sind.

## Revendications

1. Procédé de production d'une grille métallique destinée à être utilisée dans une vitre pour atténuer les conséquences de l'effet d'explosion atomique, comprenant les étapes consistant:

    a. à préparer un substrat de métal ayant une surface capable de se lier à un agent photorésistant;

    b. à appliquer une couche d'agent photorésistant sur ladite surface de métal;

    c. à exposer ledit agent photorésistant à un rayonnement actinique à travers un photomasque dans lequel est formé un dessin de grille comprenant au moins 100 ouvertures pour 6,451 cm$^2$, pour créer des zones exposées d'agent photorésistant ayant une solubilité différente de celle des zones non exposées;

    d. à développer ledit agent photorésistant dans un solvant qui en enlève des parties et laisse dégagé ledit dessin de grille sur ladite surface de métal, pour former une matrice d'électroformage;

    e. à oxyder ladite surface de métal dégagée de ladite matrice d'électroformage;

    f. à immerger ladite matrice dans une solution contenant des ions métalliques;

    g. è appliquer un potentiel électrique entre une anode et ladite matrice servant de cathode;

    h. à électrodéposer du métal sur la surface de métal dégagée de la matrice dans ledit dessin de grille;

    i. à retirer de ladite solution ladite matrice qui porte ledit dessin de grille de métal électrodéposé; et

    j. à détacher ledit dessin de grille de ladite matrice.

2. Procédé selon la revendication 1, dans lequel l'étape d'immersion de ladite matrice dans une solution contenant des ions métalliques est effectuée en utilisant une solution d'un sel métallique choisi dans le groupe constitué par le sulfamate de nickel et le sulfate de cuivre, et ladite anode comprend un métal choisi dans le groupe constitué par le nickel et le cuivre.

3. Procédé selon la revendication 1, comprenant en outre les étapes consistant:

    à immerger ladite grille de métal dans une solution contenant des ions de plomb et d'étain;

    à déposer par galvanoplastie un revêtement de plomb et d'étain sur ladite grille; et

    à traiter ledit revêtement d'étain/plomb pour l'assombrir et le durcir et réduire son facteur de réflexion.

4. Procédé selon la revendication 3, dans lequel l'étape de traitement dudit revêtement d'étain/plomb est effectuée par immersion de la grille électroformée et revêtue par galvanoplastie dans une solution acide et en procédant à un traitement électrochimique à polarité inverse.

5. Procédé selon la revendication 1, dans lequel le dessin de grille de la grille de métal est non orthogonal et comprend des segments non linéaires.

6. Pièce transparente capable d'atténuer les conséquences de l'effet d'explosion atomique, comprenant:

    a. un substrat transparent; et

    b. une grille de métal produite par électroformage, comprenant au moins 100 ouvertures pour 6,451 cm$^2$ (pouce$^2$).

7. Pièce transparente selon la revendication 6, dans laquelle ladite grille de métal produite par électroformage porte un revêtement non réfléchissant déposé par galvanoplastie.

8. Pièce transparente selon la revendication 7, dans laquelle ladite grille de métal produite par électroformage comprend un métal choisi dans le groupe constitué par le nickel et le cuivre, et ledit revêtement déposé par galvanoplastie comprend de l'étain et du plomb.

9. Pièce transparente selon la revendication 6, dans laquelle ledit substrat transparent est courbe et la grille de métal comprend des segments non linéaires pour épouser la forme du substrat courbe.

10. Pièce transparente selon la revendication 9, dans laquelle ledit dessin de grille de ladite grille est non orthogonal et comprend une série de boucles fermées, également espacées et reliées entre elles par des arcs.

EMP SHIELDING EFFECTIVENESS
VS FREQUENCY

FIG.1

FIG. 2

EMP SHIELDING EFFECTIVENESS
VS FREQUENCY

FIG. 3

FIG.4

FIG.5